Europäisches Patentamt

European Patent Office

Office européen des brevets

(11) Publication number: **0 189 975**
A1

## EUROPEAN PATENT APPLICATION

(21) Application number: 86300115.2

(22) Date of filing: 09.01.86

(51) Int. Cl.⁴: **H05K 3/42**

(30) Priority: 15.01.85 GB 8500906

(43) Date of publication of application:
06.08.86 Bulletin 86/32

(84) Designated Contracting States:
AT BE CH DE FR GB IT LI LU NL SE

(71) Applicant: **Prestwick Circuits Limited**
**Mosshill Industrial Estate**
**Ayr Scotland(GB)**

(72) Inventor: **Rivett, Christopher**
**1A Bowman Road**
**Ayr Scotland(GB)**

(74) Representative: **Wotherspoon, Graham et al**
**FITZPATRICKS 4 West Regent Street**
**Glasgow G2 1RS Scotland(GB)**

(54) Manufacture of printed circuit boards.

(57) A double sided lamination of dielectric substrate and copper foil is processed to give a p.c.b. having conductor tracks (18) formed by the original copper, and holes (16) and pads (22) plated relatively thickly.

The process comprises

- negative imaging

- etching, to give track pattern

- electroless copper plating all over

- positive pad imaging

- electroplating with copper-tin/lead or copper-nickel-tin/lead

- etching to remove unplated electroless copper

This invention relates to the manufacture of printed circuit boards, and is particularly but not exclusively applicable to double-sided boards with plated-through holes.

The most common method of making such boards uses an image of the desired tracks on photoresist which is developed to allow electrolytic plating of copper and tin/lead onto the conductors and through the holes. The photoresist is then removed to allow the base copper to be etched away. The conductors are subsequently covered with a solder resist film leaving the hole pads exposed, e.g. by silk screen printing.

This method produces conductors which are relatively thick and stand relatively proud of the board. This occurs particularly in areas of high current density during electroplating. We have found in practice that this can give rise to problems. For example, where conductor tracks run close together, it may be impossible to apply solder resist to the space between them. This process also leads to conductor tracks of varying height which can lead to problems in mounting components such as VLSI chips by automated equipment.

There has been proposed in GB-A-2 095 040 a process for manufacturing circuit boards from a base/copper laminate which gives a final product in which the conductor tracks are formed by portions of the original laminate copper only. This does result in a board having tracks of a uniform small height. However, this prior proposal relies on multiple exposures of a positive UV-sensitive liquid photoresist composition. This has severe disadvantages in practice; for example. it is necessary to conduct the entire manufacturing process in an environment which is both UV-free and highly free of dust particles.

Another prior art proposal, described in Solid State Technology, September 1968, pp 33-35, shows a sequence of process stops having some superficial resemblance to the present invention. However, this prior art process uses electroplating to build up the conductor tracks, leading to the problems outlined above. It also requires the use of gold as an etch resist which is undesirably expensive and causes accumulation of gold in the solder bath, leading to embrittled joints.

An object of the present invention is to remove or mitigate these disadvantages.

To this end, the present invention provides a method of manufacturing a printed circuit boarding comprising: providing a board having at least one face covered with a conductive foil, and drilling the board with a predetermined hole pattern; characterised by the steps of: removing the foil except in the desired track areas by application of an etch resist pattern followed by etching and removal of the resist, coating the board including the holes with a relatively thin layer of conductive material by electroless deposition, applying a plating resist to mask all areas except holes, pads and any other desired functional areas, depositing a relatively thick layer of conductive material on the unmasked areas, including the holes, by electroplating, removing the mask material, and etching away the electroless layer.

One example of the present invention will now be described, by way of example only, with reference to the drawings which schematically illustrate a p.c.b. at various stages of the process.

Laminate 10 of glass-reinforced plastic having copper foil 12, 14 bonded to both sides is cut to a suitable sheet size and stacked, for example, four high between sheets of suitable entry and exit material.

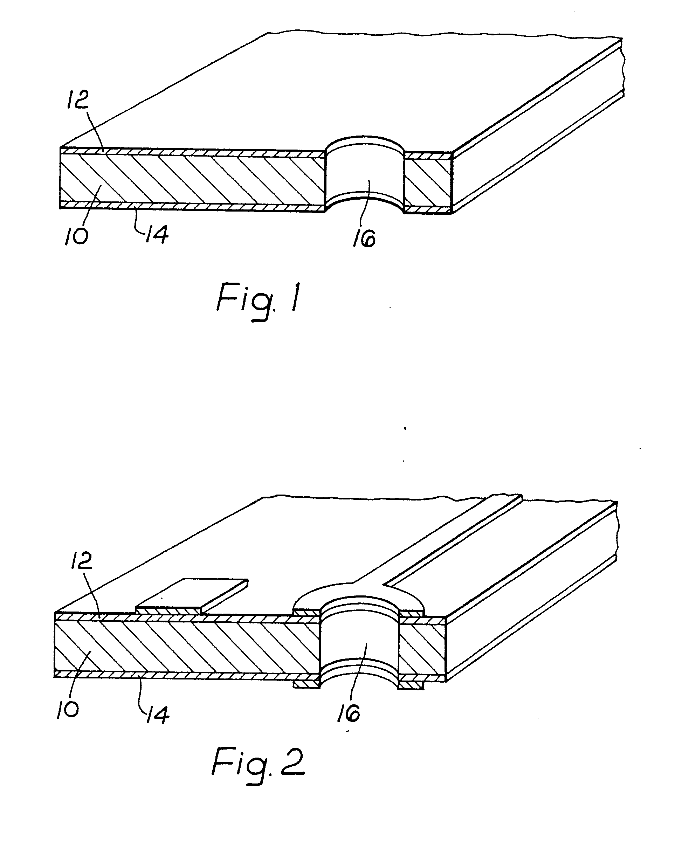

The assembly is then drilled with the desired holes, suitably by a CNC drilling machine, the laminates separated and brushed clean. One hole is shown at 16 as an example (Fig. 1).

A photosensitive dry film negative photoresist of known type is coated onto both sides.

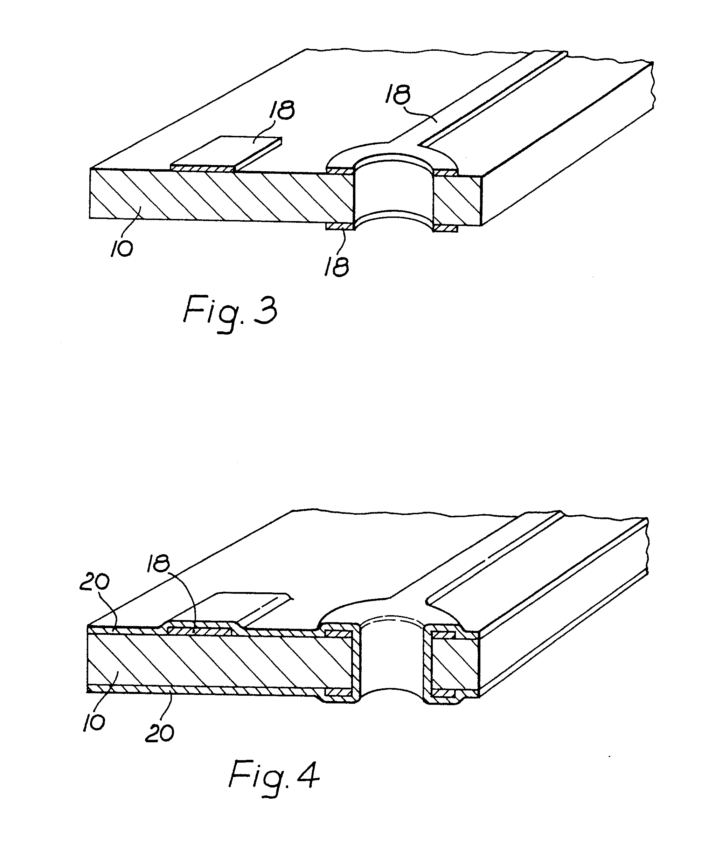

A negative image of the desired tracks is printed onto the photoresist and developed in sodium carbonate to leave the desired track areas covered (Fig. 2). The exposed copper is then etched away in ammoniacal etchant, and the photoresist removed in potassium hydroxide, to leave the desired track pattern 18 in the original copper laminate (Fig. 3).

Gold plated edge connectors (not shown) may next be formed, if desired, by means of photoresist, printing, developing, gold plating, and stripping of the photoresist.

The board with the desired copper tracks 18 is then electrolessly plated up to 2.5 $\mu$m copper 20 by catalytic deposition. This provides electrical continuity on both surfaces and through the holes for subsequent treatment (Fig. 4).

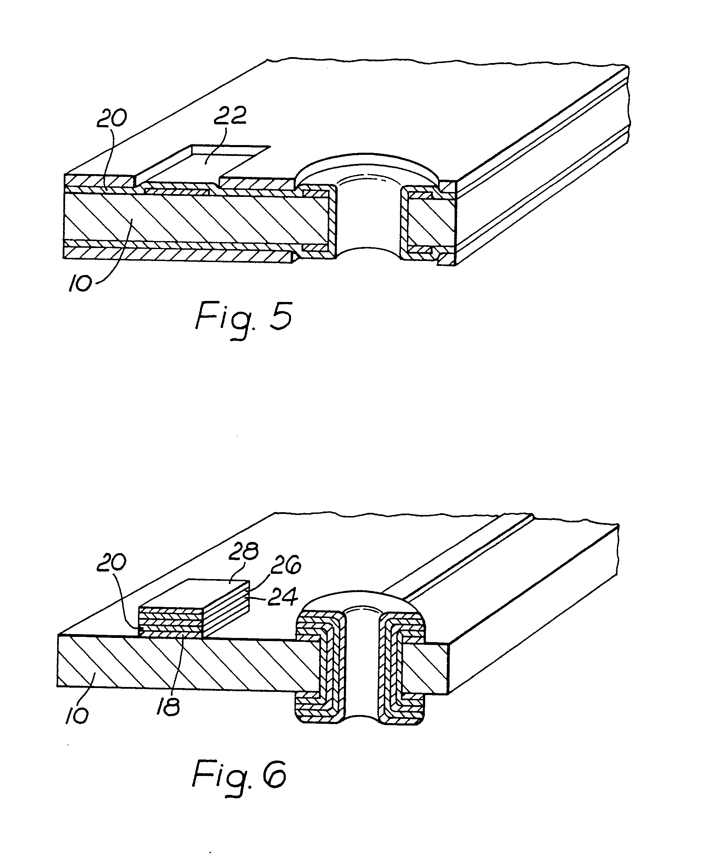

Both sides are then coated with dry film negative photoresist. A positive of the desired pad pattern is printed on the photoresist and developed in sodium carbonate to give the condition shown in Fig. 5 with pads such as 22 exposed.

The board is then electrolytically plated in three stages with copper, nickel and tin/lead to provide 20-25 $\mu$m of copper, 24, 8-12 $\mu$m of nickel 26 and 8-12 $\mu$m of tin/lead 28 on the pads and through the holes. The photoresist is then stripped in potassium hydroxide, and the electroless copper etched away in sulphuric/peroxide selective etchant. This leaves the board bearing the desired tracks in the copper of the original laminate with the pads and holes additionally plated with copper, nickel and tin/lead (Fig. 6).

Where (not shown) a solder mask is desired covering the board surface other than solder pads around the holes or blind pads for surface mounted devices, the board is then coated with photosensitive dry film negative soldermask, a positive pad image printed, and developed in sodium carbonate. The soldermask is cured by ultraviolet followed by infrared.

Finally, the board is passed through an infrared oven to reflow the tin/lead, silk screened with any desired nomenclature, profiled to size, and tested.

The process is thus based on printing to obtain the conductor tracks in the copper foil of the laminate, leading to tracks of small and uniform thickness, but with the pads and holes relatively thickly plated.

A problem experienced with prior art methods is that outgassing may occur at the holes during subsequent soldering operations, leading to cosmetically unacceptable joints. We have found that the use of an intermediate layer of nickel as described above helps to prevent outgassing problems and materially strengthens the wall of the hole. In some circumstances it is undesirable to have nickel and tin/lead in contact, and in this even the nickel can be covered with a thin layer (preferably about 5 $\mu$m) of copper before the tin/lead is plated.

Outgassing problems can also be prevented or mitigated, in a modification, by plating a relatively thick layer of copper, suitably about 30-35 $\mu$m, onto the electroless copper and depositing tin/lead on this.

## Claims

1. A method of manufacturing a printed circuit board comprising: providing a board having at least one face covered with a conductive foil, and drilling the board with a predetermined hole pattern; characterised by the steps of: removing the foil except in the desired track areas by application of an etch resist pattern followed by etching and removal of the resist,

coating the board including the holes with a relatively thin layer of conductive material by electroless deposition,

applying a plating resist to mask all areas except holes, pads and any other desired functional areas,

depositing a relatively thick layer of conductive material on the unmasked areas, including the holes, by electroplating,

removing the mask material, and

etching away the electroless layer.

2. The method of claim 1, in which the etch resist pattern is created by applying a negative photoresist material, exposing thereon a negative image of the desired pattern, and developing the photoresist.

3. The method of claim 1 or claim 2, in which the plating resist mask is created by applying a negative photoresist material, exposing thereon a positive image of the desired pad pattern, and developing the photoresist.

4. The method of any preceding claim, in which the foil is copper.

5. The method of any preceding claim, in which the electroless layer is copper, preferably about 2.5 $\mu$m thick.

6. The method of any preceding claim, in which the electroplating step comprises electroplating copper, nickel, and tin/lead in three successive stages.

7. The method of claim 6, in which a further layer of copper is electroplated between the nickel and the tin/lead.

8. The method of claim 6 or claim 7, in which the electroplated copper layer is about 20-25 $\mu$m thick, and the nickel and tin/lead layers are each about 8-12 $\mu$m thick, the further copper layer if present being about 5 $\mu$m thick.

9. The method of any of claim 1 to 5, in which the electroplating step comprises plating copper about 30-35 $\mu$m thick.

Fig. 1

Fig. 2

Fig. 3

Fig. 4

Fig. 5

Fig. 6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,X | SOLID STATE TECHNOLOGY, vol. 11, no. 9, September 1968, pages 33-35, Washington, US; G. AFFLECK et al.: "Plated through-holes with photo-etched traces" * Whole article * | 1-4 | H 05 K 3/42 |
| A | Idem | 5 | |
| D,X | GB-A-2 095 040 (LICENTIA PATENTVERWALTUNGS GmbH) * Figures 1-10; page 1, lines 9-25; page 2, lines 36-117 * | 1,4-5 | |
| A | | 6 | |
| A | US-A-4 104 111 (R.L. MACK) * Figure 1 * | 6 | TECHNICAL FIELDS SEARCHED (Int. Cl.4) H 05 K |
| A | FR-A-2 332 677 (XEROX CORP.) * Page 5 * | 6 | |
| A | US-A-4 118 523 (INTERNATIONAL COMPUTERS LTD.) * Column 4, line 54 - column 5, line 3 * | 6 | |

The present search report has been drawn up for all claims

| Place of search | Date of completion of the search | Examiner |
|---|---|---|
| THE HAGUE | 24-04-1986 | SCHUERMANS N.F.G. |